# EUROPÄISCHE PATENTSCHRIFT

(11) **EP 1 964 456 B1**
(45) Veröffentlichungstag und Bekanntmachung des Hinweises auf die Patenterteilung: **20.05.2009**
(21) Anmeldenummer: 06829418.0
(22) Anmeldetag: 08.12.2006
(51) Int. Cl.: H05K 5/06

(54) **ABDICHTUNG EINES STEUERGERÄTES**
SEALING A CONTROL DEVICE
DISPOSITIF D'ETANCHEITE POUR APPAREIL DE COMMANDE

(30) Priorität: 19.12.2005 DE 102005061050
(43) Veröffentlichungstag der Anmeldung: 03.09.2008
(73) Patentinhaber: ZF Friedrichshafen AG, 88038 Friedrichshafen (DE); Continental Automotive GmbH, 30165 Hannover (DE); Walter Söhner GmbH & Co. KG, 74193 Schwaigern (DE)
(72) Erfinder: INGENBLEEK, Robert, 88079 Kressbronn (DE); SCHWAB, Michael, 88677 Markdorf (DE); ABELE, Marc, 88048 Friedrichshafen (DE); BETZ, Thomas, 74211 Leingarten (DE); ZÖLLER, Rolf, 74336 Brackenheim (DE); REKOFSKY, Andreas, 93182 Duggendorf/Hochdorf (DE)
(86) Internationale Anmeldenummer: PCT/EP2006/011807
(87) Internationale Veröffentlichungsnummer: WO 2007/073844

(56) Entgegenhaltungen:
- EP-A- 1 154 615
- EP-A1- 0 488 879
- EP-A1- 0 777 407
- DE-A1- 2 551 360
- DE-A1- 10 324 126
- DE-A1- 10 340 974
- DE-C1- 4 324 913
- DE-C1- 19 914 469
- DE-U1- 8 705 592
- FR-A1- 2 831 384

## Beschreibung

Die Erfindung betrifft ein Gehäuse für ein elektronisches Steuergerät gemäß dem Oberbegriff des Patentanspruchs 1. Ein solches Steuergerät ist aus DE-A-10340974 bekannt.

Steuergeräte besitzen meist eine Vielzahl an elektronischen Komponenten, welche in Verbindung mit anderen Komponenten außerhalb des Steuergerätes stehen. Um Steuergeräte gegen Umwelteinflüsse oder mechanische Beanspruchungen zu schützen, werden sie normalerweise in Gehäuse eingesetzt. Damit auch so noch eine Verbindung zu außerhalb des Gehäuses liegenden Komponenten bestehen kann, ist eine elektrische Verbindung von der Gehäuseinnen- zur Gehäuseaußenseite notwendig.

Die EP 0 375 271 B1 beschreibt solch eine elektrische Verbindung. Diese Verbindung wird durch eine Trägerplatte dargestellt, auf welche Leiterbahnen gedruckt sind. Die so hergestellte Platine ist an der Verbindungsstelle zwischen einem Gehäuse und einem Deckel eingelegt und über Formdichtungen mit dem Gehäuse und dem Deckel abgedichtet. Eine elektronische Komponente im Innern des Gehäuses wird über Leitungsdrähte mit den auf die Trägerplatte gedruckten Leiterbahnen verbunden. Auf der Außenseite des Gehäuses sind wiederum Leitungsdrähte an die gedruckten Leiterbahnen gelötet, welche eine Verbindung zu einer außerhalb liegenden Komponente ermöglichen.

Nachteil dieser Anordnung ist, dass die gedruckten Leiterbahnen nicht steckbar sind, dass sie also nicht direkt über eine Steckverbindung mit weiteren Komponenten verbindbar sind. Deswegen sind bei der Verwendung von bedruckten Leiterbahnen viele Schnittstellen notwendig, da die Leiterbahnen auf der Platine über weitere Leitungsdrähte mit den jeweiligen elektrischen Komponenten verbunden werden müssen. Dabei stellt jede Schnittstelle eine potentielle Fehlerquelle dar. Außerdem ist die Herstellung einer gedruckten Leiterbahn auf einer Platine kostenintensiv. Auch die räumliche Anordnung der Schnittstellen kann nur über eine neue Platine verändert werden. Dazu kommt, dass die Verbindung der Platine mit den jeweiligen elektrischen Komponenten über einzelne Leitungsdrähte anfällig auf Vibrationen reagiert.

Um diese Nachteile zu umgehen wurde in der zum Zeitpunkt der Anmeldung noch nicht veröffentlichten DE 10 2004 033 559.1 der Anmelderin eine Abdichtung eines Gehäuses vorgeschlagen, mit welcher eine dichte Durchführung einer elektrischen Verbindung durch die Gehäusewand ermöglicht wird. Es wird vorgeschlagen, die Gehäusewand doppelwandig auszuführen und die elektrische Verbindung von der Gehäusewand fest zu umschließen. In den Zwischenraum zwischen den beiden Gehäusewandteilen wird ein Dichtmaterial eingefüllt. Das Dichtmaterial dichtet die Durchführung der elektrischen Verbindung durch die Gehäusewand sowie die Gehäusewand gegen den Deckel und/oder Boden ab. Für die Abdichtung werden allerdings hochwertige Dichtmaterialien benötigt.

Aufgabe der vorliegenden Erfindung ist es, ein Gehäuse mit einer elektrischen Verbindung durch eine Gehäusewand zu ermöglichen und die Abdichtung weiter zu verbessern.

Diese Aufgabe wird durch ein Gehäuse gemäß Patentanspruch 1 gelöst.

Es wird vorgeschlagen, ein Gehäuse auszuführen, bei dem eine elektrische Verbindung durch eine Gehäusewand durchgeführt und von der Gehäusewand fest umschlossen wird. Die Gehäusewand besitzt einen Hohlraum, in welchen Dichtmaterial eingefüllt wird. Dieser Hohlraum wird durch den Zwischenraum einer doppelwandigen Gehäusewand gebildet und ist in Richtung zu einem Deckel und/oder Boden offen. Erfindungsgemäß ist das Dichtmaterial so ausgeführt, dass es an der zum Deckel und/oder Boden ausgerichteten Seite des Hohlraums ein Dichtprofil mit mindestens zwei Dichtlippen darstellt.

Eine erste Dichtlippe ist so ausgestallet, dass sie in Richtung einer Schließbewegung ausgerichtet ist, mit der der Deckel und/oder Boden auf die Stirnseite der Gehäusewand aufgesetzt wird. Die Richtung der Schließbewegung ist vorteilhafter Weise senkrecht zur Stirnseite der Gehäusewand ausgerichtet, kann aber auch davon abweichen. Im Querschnitt des Dichtprofils zeigt sich, dass die erste Dichtlippe in der Mitte angeordnet ist. Weiterhin ist links und/oder rechts der ersten Dichtlippe mindestens eine zweite Dichtlippe angeordnet. Diese zweite Dichtlippe erstreckt sich nicht parallel, sondern schräg zur ersten Dichtlippe, wobei das freie Ende der zweiten Dichtlippe von der ersten Dichtlippe weg weisen.

Die erste Dichtlippe hat weiterhin einen Querschnitt, welcher in Richtung zur Gehäusewand hin zunimmt. Die zweite Dichtlippe hat einen Querschnitt, welcher im Wesentlichen konstant bleibt und sehr viel geringer als ihre Länge ist. Beim Aufsetzen des Deckels und/oder Bodens auf die Stirnseite der Gehäuses wird die erste Dichtlippe axial, in Richtung der Schließbewegung und in Richtung ihrer Erstreckung mit Druck beaufschlagt. Dieser Druck wird bis auf möglicher Weise auftretende Verluste auf die elektrische Verbindung weitergegeben. Die zweite Dichtlippe wird aufgrund ihrer schräg zur Richtung der Schließbewegung ausgerichteten Anordnung und ihres relativ dünnen Querschnitts im Wesentlichen auf Biegung beansprucht. Dabei wird in einer vorteilhaften Ausgestaltung die zweite Dichtlippe so gebogen, dass ihr freies Ende in Richtung zur Stirnseite der Gehäusewand verschoben wird. Gleichzeitig wird das freie Enden bei der Biegung von der ersten Dichtlippe weg, also senkrecht zur Richtung der Schließbewegung verschoben. Allerdings kann die zweite Dichtlippe auch anders angeordnet sein, wodurch eine abweichende Belegung resultieren würde.

Die erste Dichtlippe hat vor allem die Funktion, die Durchführung der elektrischen Verbindung durch die Gehäusewand abzudichten. Durch die vorteilhafte Ausgestaltung gibt die erste Dichtlippe ihre Druckbelastung sehr gut in Richtung zur elektrischen Verbindung hin weiter, wodurch diese abgedichtet wird.

Durch ihren Querschnitt, welcher sehr viel geringer als ihre Länge ist und durch ihre Ausrichtung schräg zur Richtung der Schließbewegung baut sich in der zweiten Dichtlippe durch die Belastung aufgrund der Schließbewegung sehr viel weniger Spannungen auf, als in der ersten Dichtlippe. Dadurch wird das Dichtmaterial im Bereich der zweiten Dichtlippe geringer beansprucht, als im Bereich der ersten Dichtlippe. Die Höhe der Belastung des Dichtmaterials entscheidet aber über eine elastische oder eine plastische Verformung des Dichtmaterials. Bei der erfindungsgemäßen Ausgestaltung ist vorteilhafter Weise die Verformung der zweiten Dichtlippe durch die Belastung elastisch, auch wenn die Verformung der ersten Dichtlippe bei dieser Belastung schon teilweise plastisch ist. Es wird nämlich durch die zweite Dichtlippe auch bei einer teilweise plastischen Verformung der ersten Dichtlippe eine gute Abdichtung des Deckels und/oder des Bodens mit der Gehäusewand ermöglicht. Die Durchführung der elektrischen Verbindung durch die Gehäusewand wird vorteilhafter Weise vor allem durch eine Druckbelastung, welche über die erste Dichtlippe übertragen wird, abgedichtet. Dadurch kann ein Dichtmaterial mit höherem Druckverformungsrest verwendet werden, als bei Abdichtungen, welche aufgrund Ihrer Ausgestaltung nur auf Druck beansprucht werden.

Als Materialien für die Abdichtung werden vor allem Elastomere und thermoplastische Elastomere verwendet. Dabei haben Elastomere ein Druckverformungsrest von weniger als 20 %, der Druckverformungsrest der thermoplastischen Elastomere liegt meist darüber. Erst durch die vorteilhafte Ausgestaltung des Dichtprofils ist eine Verwendung von Elastomeren, insbesondere auch von thermoplastischen Elastomeren für die erfindungsgemäße Aufgabe möglich. Natürlich können auch Dichtprofile mit mehr als zwei Dichtlippen verwendet werden. Zum Beispiel ist eine weitere vorteilhafte Ausgestaltung der Erfindung mit einer ersten und zwei zweiten Dichtlippen ausgestaltet, wobei im Querschnitt des Dichtprofils eine zweite Dichtlippe links und eine zweite Dichtlippe rechts der ersten Dichtlippe angeordnet ist.

Zur weiteren Verdeutlichung der Erfindung sowie der Ausführungsformen sind der Beschreibung zwei schematische Zeichnungen beigefügt. In dieser zeigen:
- Fig. 1: einen Schnitt durch ein erfindungsgemäßes Gehäuse und
- Fig. 2: einen Schnitt durch ein weiteres, erfindungsgemäßes Gehäuse.

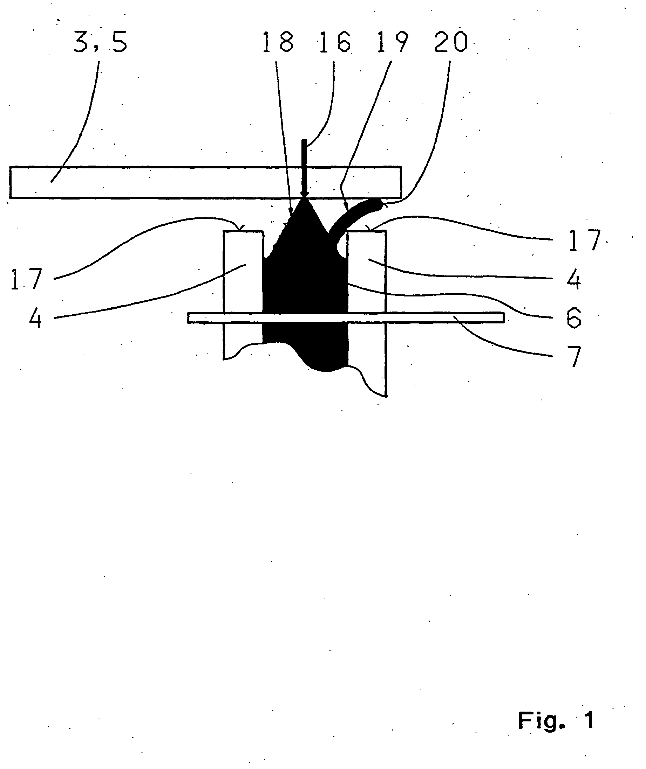

Die Fig. 1 zeigt ein Teil eines Gehäuses mit einer doppelwandigen Gehäusewand 4. Durch die Gehäusewand 4 ragt eine elektrische Verbindung 7, welche fest von der Gehäusewand 4 umschlossen ist. In den Hohlraum zwischen den beiden Wänden der Gehäusewand 4 ist das Dichtmaterial 6 zu sehen. Ein Deckel 3 wird in Richtung 16 einer Schließbewegung 16 auf die Stirnfläche 17 der Gehäusewand 4 aufgesetzt. Eine erste Dichtlippe 18 ist in Richtung 16 der Schließbewegung ausgerichtet. Der Querschnitt der ersten Dichtlippe 18 nimmt dabei in Richtung zur Gehäusewand 14 hin zu, wobei die erste Dichtlippe 18 hier mehr oder weniger die Form eines Dreiecks mit geraden Flanken besitzt. Die zweite Dichtlippe 19 ist schräg zur Richtung 16 der Schließbewegung ausgerichtet. Der Querschnitt der zweiten Dichtlippe 19 ist konstant und sehr viel kleiner als ihre Länge. Das freie Ende 20 der zweiten Dichtlippe 19 weist von der ersten Dichtlippe 18 weg.

Wird der Deckel 3 auf die Gehäusewand 4 in der Richtung 16 der Schließbewegung aufgesetzt, so wird die erste Dichtlippe 18 mit einem Druck in Richtung 16 der Schließbewegung belastet. Dieser Druck wird bis auf mögliche Verluste durch die erste Dichtlippe 18 auf die elektrische Verbindung 7 weitergegeben. Die zweite Dichtlippe 19 wird durch die Belastung aufgrund der Schließbewegung vor allem gebogen. Das freie Ende 20 der zweiten Dichtlippe 19 wird in Richtung zur Stirnseite 17 der Gehäusewand 4 verschoben. Außerdern wird sie von der ersten Dichtlippe 18 weg, also senkrecht zur Richtung 16 der Schließbewegung verschoben. Die Abdichtung entsprechend der Fig. 1 kann zum Deckel 3 und/oder Boden 5 weisen.

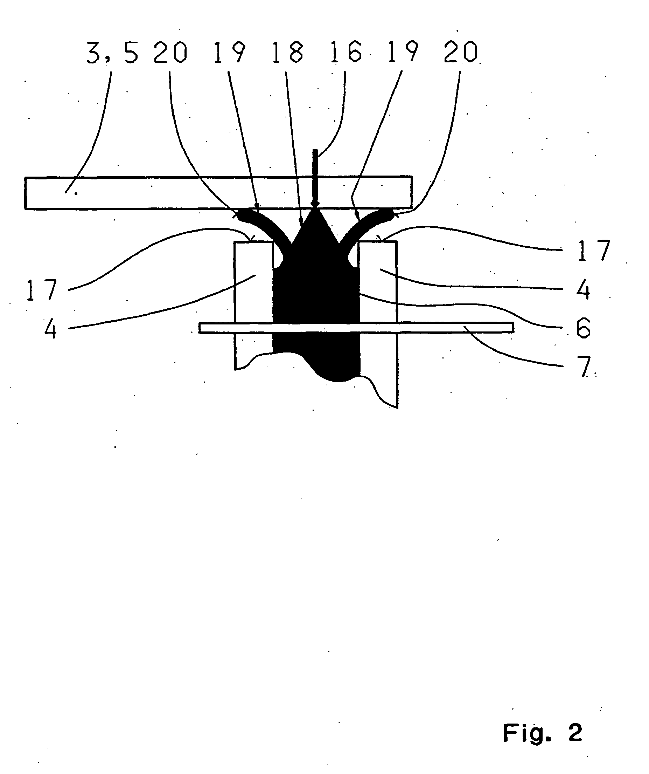

Die Fig. 2 entspricht im Wesentlichen der Fig. 1, wobei das Dichtprofil eine erste 18 und zwei zweite Dichtlippen 19 besitzt. Dabei bleiben die beiden Dichtprinzipien erhalten. Die erste Dichtlippe 18 wird mit Druck beaufschlagt und dichtet vor allem die Durchführung der elektrischen Verbindung 7 ab. Die zwei zweiten Dichtlippen 19 werden auf Biegung beansprucht und dichten das Gehäuse 4 mit dem Deckel 3 oder dem Boden 5 ab. Gleiche Ziffern bezeichnen gleiche Bauteile.

### Bezugszeichen

- 3: Deckel
- 4: Gehäusewand
- 5: Boden
- 6: Dichtmaterial
- 7: elektrische Verbindung
- 16: Richtung der Schließbewegung
- 17: Stirnseite der Gehäusewand
- 18: erste Dichtlippe
- 19: zweite Dichtlippe
- 20: freies Ende einer zweiten Dichtlippe

## Patentansprüche

1. Gehäuse für eine elektronische Vorrichtung, welches aus mindestens einer Gehäusewand (4), einem Deckel (3) und/oder einem Boden (4) besteht und welches mindestens eine elektrische Verbindung (7) zwischen einer Gehäuseinnen- und einer Gehäuseaußenseite besitzt, welche durch die Gehäusewand (4) hindurchführt, wobei die mindestens eine elektrische Verbindung (7) durch einen Hohlraum in der Gehäusewand (4) verläuft und fest von der Gehäusewand (4) umspritzt oder umpresst ist und sich in dem Hohlraum ein Dichtmaterial (6) befindet, mit welchem die Durchführung der elektrischen Verbindung (7) durch die Gehäusewand (4) abgedichtet ist sowie die Gehäusewand (4) mit einem Deckel (3) und/oder einem Boden (5) abgedichtet wird, **dadurch gekennzeichnet, dass** das Dichtmaterial in Richtung zum Deckel. (3) und/oder Boden (5) über die Gehäusewand (4) herausragt und das Dichtmaterial an der zum Deckel (3) und/oder Boden (5) gerichteten Seite mindestens zwei Dichtlippen (18, 19) besitzt, wobei eine erste Dichtlippe (18) in Richtung (16) einer Schließbewegung ausgerichtet ist, eine zweite Dichtlippe (19) schräg zur Richtung (16) der Schließbewegung ausgerichtet ist und die zweite Dichtlippe (19) mit ihrem freien Ende (20) von der ersten Dichtlippe (18) weg zum Deckel (3) und/oder Boden (5) gerichtet ist.

2. Gehäuse nach Anspruch 1, **dadurch gekennzeichnet, dass** die erste Dichtlippe (18) in ihrem Querschnitt in Richtung zur Gehäusewand (4) hin zunimmt und der Querschnitt der zweiten Dichtlippe (19) im wesentlichen konstant bleibt.

3. Gehäuse nach Anspruch 2, **dadurch gekennzeichnet, dass** der Querschnitt der erste Dichtlippe (18) dreiecksförmig ausgebildet ist.

4. Gehäuse nach einem der vorherigen Ansprüche, **dadurch gekennzeichnen**, dass die erste Dichtlippe (18) so in Richtung Deckel (3) und/oder Boden (5) ausgerichtet ist, dass bei einem Verschließen des Deckels (3) und/oder des Bodens (5) mit der Gehäusewand (4) die erste Dichtlippe (18) in Richtung (16) der Schließbewegung mit einer Drucklast beaufschlagt wird und die erste Dichtlippe (18) diese Drucklast auf die elektrische Verbindung (7) weiterleitet.

5. Gehäuse nach einem der vorherigen Ansprüche, **dadurch gekennzeichnet, dass** bei einem Verschließen des Deckels (3) und/oder des Bodens (5) mit der Gehäusewand (4) die zweite Dichtlippen (19) in Richtung (16) der Schließbewegung mit einer Last beaufschlagt wird und **dadurch** das freie Ende (20) der zweiten Dichtlippe (19) in Richtung (16) der Schließbewegung zur Gehäusewand (4) hin und gleichzeitig senkrecht zur Richtung (16) der Schließbewegung von der ersten Dichtlippe (18) weg gebogen wird.

6. Gehäuse nach einem der vorherigen Ansprüche, **dadurch gekennzeichnet, dass** im Querschnitt des Dichtprofils mindestens eine zweite Dichtlippe (19) auf der linken und mindestens eine zweite Dichtlippe (19) auf der rechten Seite der ersten Dichtlippe (18) angebracht ist.

7. Gehäuse nach einem der vorherigen Ansprüche, **dadurch gekennzeichnet, dass** das Dichtmaterial (6) aus Elastomeren oder thermoplastischen Elastomeren besteht.

## Claims

1. Housing for an electronic apparatus, which housing comprises at least one housing wall (4), a cover (3) and/or a base (5) and has at least one electrical connection (7) between a housing inner face and a housing outer face, this electrical connection being conducted through the housing wall (4), with the at least one electrical connection (7) running through a cavity in the housing wall (4) and being encapsulated or surrounded by pressing firmly by the housing wall (4), and a sealing material (6) being located in the cavity, this sealing material being used to seal off the bushing of the electrical connection (7) through the housing wall (4), and the housing wall (4) being sealed off by way of a cover (3) and/or a base (5), **characterized in that** the sealing material projects beyond the housing wall (4) in the direction towards the cover (3) and/or base (5) and the sealing material has at least two sealing lips (18, 19) on that side which is directed towards the cover (3) and/or base (5), with a first sealing lip (18) being oriented in the direction (16) of a closing movement, a second sealing lip (19) being oriented transverse to the direction (16) of the closing movement, and the second sealing lip (19) being directed away from the first sealing lip (18) and towards the cover (3) and/or base (5) by way of its free end (20).

2. Housing according to Claim 1, **characterized in that** the cross section of the first sealing lip (18) increases in the direction of the housing wall (4), and the cross section of the second sealing lip (19) remains substantially constant.

3. Housing according to Claim 2, **characterized in that** the cross section of the first sealing lip (18) is triangular.

4. Housing according to one of the preceding claims, **characterized in that** the first sealing lip (18) is oriented in the direction of the cover (3) and/or base (5) such that, when the cover (3) and/or the base (5) is closed, the housing wall (4) subjects the first sealing lip (18) to the action of a pressure load in the direction (16) of the closing movement, and the first sealing lip (18) passes on this pressure load to the electrical connection (7).

5. Housing according to one of the preceding claims, **characterized in that**, when the cover (3) and/or the base (5) is closed, the housing wall (4) subjects the second sealing lip (19) to the action of a load in the direction (16) of the closing movement and, as a result, the free end (20) of the second sealing lip (19) is bent towards the housing wall (4) in the direction (16) of the closing movement and, at the same time, is bent away from the first sealing lip (18) perpendicular to the direction (16) of the closing movement.

6. Housing according to one of the preceding claims, **characterized in that**, as seen in cross section of the sealing profile, at least one second sealing lip (19) is fitted on the left-hand side and at least one second sealing lip (19) is fitted on the right-hand side of the first sealing lip (18).

7. Housing according to one of the preceding claims, **characterized in that** the sealing material (6) comprises elastomers or thermoplastic elastomers.

## Revendications

1. Boîtier pour un dispositif électronique, qui se compose d'au moins une paroi de boîtier (4), d'un couvercle (3) et/ou d'un fond (5), et qui possède au moins une connexion électrique (7) entre un côté intérieur et un côté extérieur du boîtier, qui passe à travers la paroi de boîtier (4), l'au moins une connexion électrique (7) s'étendant à travers une cavité dans la paroi de boîtier (4) et étant surmoulée ou revêtue fixement par la paroi de boîtier (4), un matériau d'étanchéité (6) se trouvant dans la cavité, avec lequel le passage de la connexion électrique (7) à travers la paroi de boîtier (4) est rendu étanche, la paroi de boîtier (4) étant fermée hermétiquement avec un couvercle (3) et/ou un fond (5), **caractérisé en ce que** le matériau d'étanchéité ressort au-delà de la paroi de boîtier (4) dans la direction du couvercle (3) et/ou du fond (5) et le matériau d'étanchéité possède, au niveau du côté orienté vers le couvercle (3) et/ou le fond (5), au moins deux lèvres d'étanchéité (18, 19), une première lèvre d'étanchéité (18) étant orientée dans la direction (16) d'un mouvement de fermeture, une deuxième lèvre d'étanchéité (19) étant orientée obliquement par rapport à la direction (16) du mouvement de fermeture et la deuxième lèvre d'étanchéité (19) étant orientée avec son extrémité libre (20) en partant de la première lèvre d'étanchéité (18) vers le couvercle (3) et/ou le fond (5).

2. Boîtier selon la revendication 1, **caractérisé en ce que** la première lèvre d'étanchéité (18) a une section transversale qui augmente dans la direction de la paroi de boîtier (4) et la section transversale de la deuxième lèvre d'étanchéité (19) reste essentiellement constante.

3. Boîtier selon la revendication 2, **caractérisé en ce que** la section transversale de la première lèvre d'étanchéité (18) est réalisée sous forme triangulaire.

4. Boîtier selon l'une quelconque des revendications précédentes, **caractérisé en ce que** la première lèvre d'étanchéité (18) est orientée dans la direction du couvercle (3) et/ou du fond (5) de telle sorte que, dans le cas d'une fermeture du couvercle (3) et/ou du fond (5) avec la paroi de boîtier (4), la première lèvre d'étanchéité (18) soit sollicitée avec une contrainte de pression dans la direction (16) du mouvement de fermeture, et la première lèvre d'étanchéité (18) transfère cette contrainte de pression à la connexion électrique (7).

5. Boîtier selon l'une quelconque des revendications précédentes, **caractérisé en ce que**, dans le cas d'une fermeture du couvercle (3) et/ou du fond (5) avec la paroi de boîtier (4), la deuxième lèvre d'étanchéité (19) est sollicitée avec une contrainte dans la direction (16) du mouvement de fermeture et de ce fait l'extrémité libre (20) de la deuxième lèvre d'étanchéité (19) est cintrée dans la direction (16) du mouvement de fermeture vers la paroi de boîtier (4) et simultanément perpendiculairement à la direction (16) du mouvement de fermeture à l'écart de la première lèvre d'étanchéité (18).

6. Boîtier selon l'une quelconque des revendications précédentes, **caractérisé en ce que** dans la section transversale du profilé d'étanchéité, au moins une deuxième lèvre d'étanchéité (19) est montée sur le côté gauche et au moins une deuxième lèvre d'étanchéité (19) est montée sur le côté droit de la première lèvre d'étanchéité (18).

7. Boîtier selon l'une quelconque des revendications précédentes, **caractérisé en ce que** le matériau d'étanchéité (6) se compose d'élastomères ou d'élastomères thermoplastiques.
